# EUROPEAN PATENT SPECIFICATION

(11) **EP 2 656 144 B1**
(45) Date of publication and mention of the grant of the patent: **24.06.2020**
(21) Application number: 11799167.9
(22) Date of filing: 19.12.2011
(51) Int. Cl.: G03F 7/031, G03F 7/027, G03F 7/20, G03F 7/18, B41C 1/00

(54) **A CURABLE JETTABLE FLUID FOR MAKING A FLEXOGRAPHIC PRINTING MASTER**
HÄRTBARE, STRAHLBARE FLÜSSIGKEIT ZUR HERSTELLUNG EINER FLEXOGRAPHISCHEN DRUCKVORLAGE
FLUIDE APPROPRIÉ AU JET ET DURCISSABLE POUR LA FABRICATION D'UNE MATRICE D'IMPRESSION FLEXOGRAPHIQUE

(30) Priority: 20.12.2010 EP 10195896; 21.12.2010 US 201061425277 P
(43) Date of publication of application: 30.10.2013
(73) Proprietor: AGFA NV, 2640 Mortsel (BE)
(72) Inventor: VANMAELE, Luc, 2640 Mortsel (BE); DAEMS, Eddie, 2640 Mortsel (BE)
(74) Representative: Strijckers, Hans Louis P.
(86) International application number: PCT/EP2011/073224
(87) International publication number: WO 2012/084811

(56) References cited:
- EP-A1- 2 033 949
- EP-A1- 2 199 273
- WO-A1-97/16469
- WO-A1-2005/089957
- JP-A- 2009 191 179
- US-A- 6 130 980
- US-A1- 2005 261 388

## Description

### FIELD OF THE INVENTION

The present invention relates to a curable jettable fluid for making a flexographic printing master and to a method for making a flexographic printing master by inkjet.

### BACKGROUND OF THE INVENTION

Flexography is today one of the most important printing techniques. It is used for printing on a variety of substrates such as paper, paperboard stock, corrugated board, films, foils and laminates. Coarse surfaces and stretch films can only be printed economically with flexography, making it indeed very appropriate for packaging material printing.

Today flexographic printing masters are prepared by both analogue and digital imaging techniques. Analogue imaging typically uses a film mask through which a flexographic printing precursor is exposed. Digital imaging techniques include:
- Direct laser engraving as disclosed in e.g. EP-As 1710093 and 1936438;
- UV exposure through a LAMS mask wherein LAMS stands for Laser Ablative Mask System as disclosed in e.g. EP-A 1170121;
- Direct UV or violet exposure by laser or LED as disclosed in e.g. US6806018; and
- Inkjet printing as disclosed in e.g. EP-As 1428666 and 1637322.

The major advantage of an inkjet method for preparing a flexographic printing master is an improved sustainability due to the absence of any processing steps and the consumption of no more material as necessary to form a suitable relief image (i.e. removal of material in the non printing areas is no longer required).

EP-A 641648 discloses a method of making a photopolymer relief-type printing plate wherein a positive or negative image is formed on a substrate by inkjet printing with a photopolymeric ink, optionally preheated to a temperature between 30 and 260°C and subjecting the resulting printed substrate to UV radiation, thereby curing the ink composition forming the image.
US6520084 discloses a method of preparing flexographic printing masters by inkjet wherein a removable filler material is used to support the relief image being printed and wherein the relief image is grown in inverted orientation on a substrate. Disadvantages of this method are the removal of the filler material and the release of the relief image from the substrate.
EP-A 1428666 discloses a method of making a flexographic printing master by means of jetting subsequent layers of a curable fluid on a flexographic support. Before jetting the following layer, the previous layer is immobilized by a curing step.
In US7036430 a flexographic printing master is prepared by inkjet wherein each layer of ink is first jetted and partially cured on a blanket whereupon each such layer is then transferred to a substrate having an elastomeric floor, thereby building up the relief image layer by layer. A similar method is disclosed in EP-A 1449648 wherein a lithographic printing plate is used to transfer such layers of ink to a substrate.
US20080053326 discloses a method of making a flexographic printing master by inkjet wherein successive layers of a polymer are applied to a specific optimized substrate. In US20090197013, also disclosing an inkjet method of making a flexographic printing master, curing means are provided to additionally cure, for example, the side surfaces of the image relief being formed. In EP-A 2223803 a UV curable hot melt ink is used. Each of the deposited layers of ink is gelled before the deposition of a subsequent layer on the deposited layer. After the printing master with sufficient thickness is formed, the ink is cured.

EP-As 1637926 and 1637322 disclose a specific curable jettable fluid for making flexographic printing masters comprising a photo-initiator, a monofunctional monomer, a polyfunctional monomer or oligomer and at least 5 wt. of a plasticizer. The presence of the plasticizer is necessary to obtain a flexographic printing master having the necessary flexibility. Also in EP-A 2033778, the curable jettable fluid for making a relief image by inkjet on a sleeve body contains a plasticizer.

A flexographic printing master formed on a support by an inkjet method typically comprises an elastomeric floor, an optional mesa relief and an image relief as disclosed in EP-A 2199082.

To realize a high resolution with such an inkjet method, particularly for printing the image relief which determines the finally printed image, it is advantageous to use a printhead with small nozzle diameters, for example producing 3 pl fluid droplets. However, such a small nozzle diameter requires low viscosity inks.

An important drawback of commonly used photo-initiators, for example those disclosed in EP-As 1637926 and EP1637322, is the migration of unreacted molecules to the surface of the image relief. Also, during the flexographic printing process itself, the UV-cured flexographic printing master is contacted with printing ink, being water- or solvent-based or UV-curable. A commonly used photo-initiator may be (slowly) extracted from the printing image relief, causing a shrinkage in relief thickness and changes in physical properties of the relief and as a result thereof of the printing properties of the flexographic printing master.
EP2199273A and EP2033949A disclose curable compositions comprising copolymerizable photo-initiators and polymerisable co-initiators. The radiation curable compositions however do not lead to layers after curing which are suitable for flexographic printing masters due to the high hardness and low flexibility. WO97/16469 disclose curable compositions for coating of glass fibres and comprising copolymerizable photo-initiators. The compositions allow to produce the coatings free of solvents. US2005/0261388 shows examples of UV-curable compositions comprising a copolymerizable photoinitiator to obtain any desired coating performance. US6130980 discloses curable compositions for coating of glass fibres showing an improved adhesion. The coating compositions comprise a P-containing photo-initiator.

### SUMMARY OF THE INVENTION

It is an object of the present invention to provide a curable jettable fluid for making a flexographic printing master by inkjet, said flexographic printing master having excellent printing properties that do not change during printing.

The object of the present invention is realized with a curable jettable fluid for making a flexographic printing master comprising an initiator, a cyclic monofunctional (meth)acrylate monomer and a difunctional (meth)acrylate monomer characterized in that the initiator is an oligomer, a polymer or a copolymerizable compound, the difunctional (meth)acrylate monomer is a polyalkylene glycol di(meth)acrylate, and the cyclic monofunctional (meth)acrylate monomer is selected from the group of isobornyl acrylate, tetrahydrofurfuryl methacrylate, 4-t.butylcyclohexyl acrylate, dicyclopentadienyl acrylate, dioxalane functional acrylates, cyclic trimethylolpropane formal acrylate, 2-phenoxyethyl acrylate, 2-phenoxyethyl methacrylate, tetrahydrofurfuryl acrylate and 3,3,5-trimethyl cyclohexyl acrylate.

### BRIEF DESCRIPTION OF THE DRAWINGS

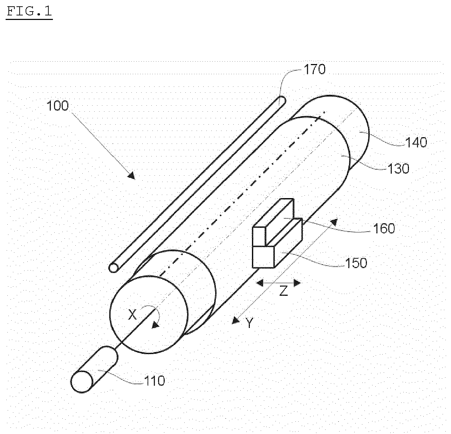

Figure 1 shows an embodiment of an apparatus for printing a flexographic printing master on a cylindrical sleeve.

### DETAILED DESCRIPTION OF THE INVENTION

The curable jettable fluid for making a flexographic printing master according to the present invention comprises an initiator, a polyalkylene glycol di(meth)acrylate as a difunctional (meth)acrylate monomer, a cyclic monofunctional (meth)acrylate monomer selected from the group of isobornyl acrylate, tetrahydrofurfuryl methacrylate, 4-t.butylcyclohexyl arylate, dicyclopentadienyl acrylate, dioxalane functional acrylates, cyclic trimethylolpropane formal acrylate, 2-phenoxyethyl acrylate, 2-phenoxyethyl methacrylate, tetrahydrofurfuryl acrylate and 3,3,5-trimethyl cyclohexyl acrylate characterized in that the initiator is a an oligomer, a polymer or a copolymerizable compound. The curable jettable fluid may further comprise urethane acrylate oligomers, polymerization inhibitors, compounds which decrease oxygen inhibition during polymerization, elastomers, surfactants, colorants, solvents, humectants and/or biocides.

### Initiator

The initiator is an oligomer, a polymer or a copolymerizable compound.

The initiator may be a thermal initiator, which forms high-energy species, upon applying heat or IR-radiation to the jetted fluids. However, the initiator is preferably a photo-initiator which, upon absorption of actinic radiation, preferably UV-radiation, forms the high-energy species, for example radicals or cations, inducing polymerization and crosslinking of the monomers and oligomers present in the jettable curable liquid.

Photo-initiators for radical polymerizations can be classified into Norrish type I and II photo-initiators. Norrish type I photo-initiators can be photo-fragmented into primary radicals by radiation. These primary radials then may initiate the polymerization reaction. Norrish type II photo-initiators on the other hand require the presence of a so called co-initiator, such as aliphatic tertiary amines, aromatic amines, and thiols. After transfer of a hydrogen atom from the co-initiator to the Norrish type II initiator, the radical generated at the co-initiator may initiate the polymerization reaction.

Typical Norrish type II photo-initiators are not incorporated into the polymer network after curing. Theoretically, the co-initiator is built into the polymer network upon photocrosslinking, however, hydrogen transfer from the co-initiator to the Norrish type II initiator and the initiating efficiency of the primary radicals generated at the co-initiator are rarely quantitative, resulting in unreacted co-initiator and other side products.

In cured layers obtained with such radiation curable composition, low molecular weight residues remain mobile and might be extracted. Furthermore, these low molecular weight residues may also deteriorate the physical properties of the cured composition.

It has now been found that the tendency to migrate and the possibility of being extracted could be reduced significantly when using as initiator and/or co-initiator an oligomer, a polymer or a copolymerizable compound.

A preferred total amount of initiator is 1 to 10 wt.%, more preferably 2.5 to 7.5 wt.%, of the total curable jettable liquid weight. A preferred total amount of co-initiators is 1 to 20 wt.%, more preferably 2.5 to 15 wt.%, most preferably 5 to 10 wt.% of the total curable jettable liquid weight.

Irradiation with actinic radiation may be realized in two steps, each step using actinic radiation having a different wavelength and/or intensity. In such cases it is preferred to use 2 types of photo-initiators, chosen in function of the different actinic radiation used.

### Copolymerizable initiator

Examples of copolymerizable photo-initiators are depicted in the following table.

| |
|---|
| 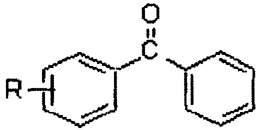 |
| wherein R is an acrylic group |
| 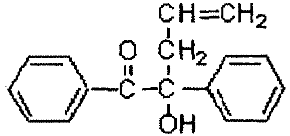 |
| 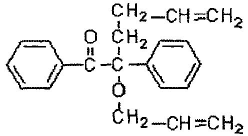 |
| 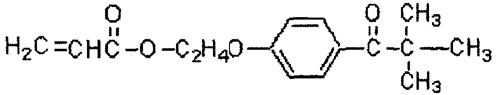 |
| 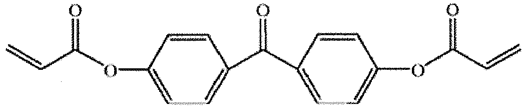 |
| 4,4-diacryloyloxybenzophenone (DABP) |

A particularly preferred copolymerizable photo-initiator is EBECRYL® P 36, an acrylated benzophenone derivative from Cytec.

Also the copolymerizable photo-intiators described in EP-As 2033949, 2199273, 2065362, 2161264, 2130818 and 2130817 may be used.

Optionally, co-initiators may be used with the photo-initiator. Examples of co-initiators include: triethanolamine, methyldiethanolamine, triisopropanolamine, 4,4'-dimethylamino benzophenone, 4,4'-diethylamino benzophenone, 2-dimethylamino ethylbenzoate, 4-dimethylamino ethylbenzoate, 2-n-buthoxyethyl-4-dimethylaminobenzoate and others. Preferably a polymeric type co-initiator is used such as for example Genopol AB-1 (from Rahn), which is a polymeric aminobenzoate derivative. Other polymeric co-initiators are dislosed in EP-A 1616897 and WO2008074759. Even more preferred, copolymerizable co-initiators are used. Copolymerizable co-intiators are for example CN371, CN373, CN384 and CN386, all acryated amines form SARTOMER. Other copolymerizable co-initiators are disclosed in EP-A 2161290 may be used.

The copolymerizable photo-initiators may be used in combination with conventional initiators, such as for example disclosed in EP 1 637 926 paragraph [0077] to [0079] or with the oligomeric or polymeric initiators described below.

Combinations of copolymerizable photo-initiators with conventional co-initiators, and/or oligomeric or polymeric co-initiators and/or copolymerizable co-initiators may also be used.

### Oligomeric or polymeric initiators

Oligomeric or polymeric photo-initiators having a relatively low viscosity and high functionality are preferred.

Preferred polymeric photo-initiators are based on aromatic ketones, which are used in a bimolecular initiating system (Norrish Type II).

Polymeric benzophenones and polymeric multifunctional thioxanthones, are both particularly preferred.

Examples of polymeric photo-initiators are:
Genopol TX1 (from Rahn), a multifunctional thioxanthone derivative.
Genopol BP1 (from Rahn), a multifunctional benzophenone derivative.
Omnipol BP (from IGM Resins), a difunctional benzophenone derivative.
Omnipol TX (from IGM Resins), a difunctional thioxanthone derivative.

Other polymeric initiators are disclosed in EP-As 1616920 and 2033949.

An example of a polymeric co-initiator is Genopol AB-1 (from Rahn) which is a polymeric aminobenzoate derivative.

Genopol TX-1 is preferably used in combination with Genopol AB-1 to ensure an efficient polymerization.

Other polymeric co-initiators are dislosed in EP-A 1616897 and WO2008074759.

EP-A 1616899 discloses polymers which have both a co-initiating and an initiating functional group.

Preferably a polymeric or oligomeric photo-initiator is used in combination with a polymeric or oligomeric co-initiator. However, the polymeric or oligomeric photo-initiator may also be used in combination with conventional co-initiators, or conventional photo-initiators may be used in combination with polymeric or oligomeric co-initiators.

The oligomeric or polymeric initiators and/or co-initiators may also be used in combination with conventional initiators, such as for example disclosed in EP 1 637 926 paragraph [0077] to [0079] or with the copolymerizable initiators described above.

### Cyclic monofunctional (meth)acrylate monomer

The curable jettable fluid comprises a cyclic monofunctional (meth)acrylate monomer selected from the group of isobornyl acrylate (SR506D from Sartomer), tetrahydrofurfuryl methacrylate (SR203 from Sartomer), 4-t.butylcyclohexyl arylate (Laromer TBCH from BASF), dicyclopentadienyl acrylate (Laromer DCPA from BASF), dioxalane functional acrylates (CHDOL10 and MEDOL10 from San Esters Corporation), cyclic trimethylolpropane formal acrylate (SR531 from Sartomer), 2-phenoxyethyl acrylate (SR339C from Sartomer), 2-phenoxyethyl methacrylate (SR340 from Sartomer), tetrahydrofurfuryl acrylate (SR285 from Sartomer)and 3,3,5-trimethyl cyclohexyl acrylate (CD420 from Sartomer).

Particularly preferred cyclic monofunctional (meth)acrylates monomers are isobornyl acrylate (IBOA) and 4-t.butylcyclohexyl arylate (Laromer TBCH from BASF).

In the present invention, the cyclic monofunctional (meth)acrylate monomers referred to in the description and the claims do not encompass copolymerizable initiators or co-initiators, which may also be cyclic monofunctional acrylates, e.g. those disclosed in EP 2 199 273 or EP 2 033 949.

The amount of the cyclic monofunctional (meth)acrylate monomer is preferably at least 40 wt.% of the total monomer content.

### Difunctional (meth)acrylate monomer

The difunctional (meth)acrylate monomer is a polyalkylene glycol di(meth)acrylate. Such compounds have two acrylate or methacrylate groups attached by an ester linkage at the opposite ends of a hydrophilic polyalkylene glycol.
Typically, the longer the length of the polyalkylene chain, the softer and more flexible the obtained layer after curing.
Examples of such polyalkylene glycol di(meth)acrylates include: 1,3-butylene glycol diacrylate, 1,3-butylene glycol dimethacrylate, diethylene glycol diacrylate, diethylene glycol dimethacrylate, dipropylene glycol diacrylate, ethylene glycol dimethacrylate, polyethylene glycol (200) diacrylate, polyethylene glycol (400) diacrylate, polyethylene glycol (400) dimethacrylate, polyethylene glycol (600) diacrylate, polyethylene glycol (600) dimethacrylate, polyethylene glycol dimethacrylate, polypropylene glycol (400) dimethacrylate, tetraethylene glycol diacrylate, tetraethylene glycol dimethacrylate, triethylene glycol diacrylate, triethylene glycol dimethacrylate, tripropylene glycol diacrylate, tripropylene glycol diacrylate, and combinations thereof. The number between brackets in the above list refers to the Molecular Weight (MW) of the polyalkylene chain.
Highly preferred polyalkylene glycol diacrylates are polyethylene glycol diacrylates. Specific examples of commercially available polyethylene glycol diacrylate monomers include SR259 [polyethylene glycol (200) diacrylate], SR344 [polyethylene glycol (400) diacrylate], SR603 [polyethylene glycol (400) dimethacrylate], SR610 [polyethylene glycol (600) diacrylate], SR252 [polyethylene glycol (600) dimethacrylate], all Sartomer products; EBECRYL 11 [poly ethylene glycol diacrylate from Cytec; Genomer 1251 [polyethylene glycol 400 diacrylate] from Rahn.
Polyethylene glycol (600) diacrylate, available as SR610 from Sartomer, is particularly preferred.

The amount of the difunctional (meth)acrylate is preferably at least 10 wt.% of the total monomer content.

### Plasticizer

In principle, a plasticizer as disclosed in EP-As 1637926 and 1637322 may be used. However, such plasticizers have as major disadvantage that they may migrate towards the surface of the image relief as a function of time or may be extracted out of the relief image by the printing ink during the flexographic printing process. This may result in a change of the physical properties of the relief image and as a result thereof of the printing properties of the flexographic printing master. In addition, adding a plasticizer as disclosed in EP-As 1637926 and 1637322 often results in a too high viscosity of the fluid making it not suitable for printheads with small nozzle diameters.

Therefore, a copolymerizable plasticizing monomer selected from the group consisting of diallyl phthalate and a low Tg monomer, of which the corresponding homopolymer has a glass transition temperature (Tg) below -15°C, is preferably used in the jettable curable fluid according the present invention.

A plasticizing monomer is a monomer capable of reacting with itself and the other monomers present in the jettable fluid and resulting in polymers or copolymers having an increased flexibility compared with the polymers or copolymers formed by only the other monomers without such plasticizing monomers (see also US6235916 col.4; In.9). A low Tg monomer is defined as a monomer of which the corresponding homopolymer has a glass transition temperature Tg (as determined by DSC) lower than -15°C. Preferably, monomers are used of which the corresponding homopolymer has a Tg lower than -25°C, more preferably lower than -35°C.

According to a preferred embodiment, the low Tg monomer is a long chain alkyl monofunctional acrylate monomer, preferably a C8-C16 alkyl monofunctional acrylate monomer.

Particularly preferred low Tg monomers are long chain alkyl monoacrylates such as SR489 (tridecyl acrylate; Tg = -55°C), SR395 (isodecyl acrylate; Tg = -60°C) and SR 335 (laurylacrylate; Tg = -30°C) all commercially available from SARTOMER.

Also preferred low Tg monomers are CD278 (a monofunctional acrylate ester with a Tg = -74°C), SR256 (2(2-ethoxyethoxy)-ethyl acrylate; Tg = -54°C), CN152 (aliphatic epoxy monoacrylate; Tg = -35°C), SR285 (tetrahydrofurfuryl acrylate; Tg = -28°C), SR504 (ethoxylated nonyl phenol acrylate; Tg = -27°C), SR495 (caprolactone acrylate; Tg = -53°C) and SR9021(a highly propoxylated glyceryl triacrylate; Tg = -11°C).

The low Tg monomers are preferably present in a concentration between 2 and 25 wt.%, more preferably between 5 and 20 wt.% with respect to the total weight of the curable mixture.

According to another embodiment of the present invention, it has been found that the flexographic printing master with sufficient flexibility can also be obtained when instead of a plasticizer as disclosed in EP-As 1637926 and 1637322, diallyl phthalate (DAP) is added to the curable jettable fluid in addition to the cyclic monofunctional acrylate monomer and the difunctional (meth)acrylate monomer.

The amount of DAP in the curable jettable fluid is preferably between 2 and 25 wt.%, more preferably between 5 and 20 wt.% with respect to the total weight of the curable mixture.

According to a preferred embodiment, the jettable curable fluid comprises a copolymerizable initiator and at least 50 wt.% of a mixture of a cyclic monofunctional acrylate monomer, a difunctional (meth)acrylate monomer and a copolymerisable plasticizing monomer selected from the group consisting of diallyl phthalate and a low Tg monomer, of which the corresponding homopolymer has a glass transition temperature (Tg) below -15°C.

### Monofunctional urethane acrylate

The curable jettable fluid may further comprise a monofunctional urethane acrylate oligomer.

Urethane acrylates oligomers are well known and are prepared by reacting polyisocyanates with hydroxyl alkyl acrylates, usually in the presence of a polyol compound. Their functionality (i.e. number of acrylate groups) varies from 1 to 6. A lower functionality results in lower reactivity, better flexibility and a lower viscosity. Therefore, monofunctional urethane acrylate oligomers are used in the present invention. The polyol compound forms the backbone of the urethane acrylate. Typically the polyol compounds are polyether or polyester compounds with a functionality (hydroxyl groups) ranging from two to four. Polyether urethane acrylates are generally more flexible, provide lower cost, and have a slightly lower viscosity and are therefore preferred.

The most preferred monofunctional urethane acrylate oligomers are monofunctional aliphatic urethane acrylates having a very low viscosity of 100 mPa.s or lower at 25°C, like for example Genomer 1122 (2-acrylic acid 2-{[(butylamino)carbonyl]oxy}ethyl ester, available from Rahn AG) and Ebecryl 1039 (available from Cytec Industries Inc.).

The total amount of the monofunctional urethane acrylate oligomer is preferably at least 10 wt.% of the total monomer content.

### Other monomers or oligomers

Additional mono- or multifunctional monomers or oligomers may be used to further optimize the properties of the curable jettable fluid.

### Inhibitors

Suitable polymerization inhibitors include phenol type antioxidants, hindered amine light stabilizers, phosphor type antioxidants, hydroquinone monomethyl ether commonly used in (meth)acrylate monomers, and hydroquinone, methylhydroquinone, t-butylcatechol, pyrogallol may also be used. Of these, a phenol compound having a double bond in molecules derived from acrylic acid is particularly preferred due to its having a polymerization-restraining effect even when heated in a closed, oxygen-free environment. Suitable inhibitors are, for example, Sumilizer® GA-80, Sumilizer® GM and Sumilizer® GS produced by Sumitomo Chemical Co., Ltd.
Since excessive addition of these polymerization inhibitors will lower the sensitivity to curing of the curable jettable liquid, it is preferred that the amount capable of preventing polymerization be determined prior to blending. The amount of a polymerization inhibitor is generally between 200 and 20 000 ppm of the total curable jettable liquid weight.

### Oxygen inhibition

Suitable combinations of compounds which decrease oxygen polymerization inhibition with radical polymerization inhibitors are: 2-benzyl-2-dimethylamino-1-(4-morpholinophenyl)-butane-1 and 1-hydroxy-cyclohexyl-phenyl-ketone; 1-hydroxy-cyclohexyl-phenyl-ketone and benzophenone; 2-methyl-1[4-(methylthio)phenyl]-2-morpholinopropane-1-on and diethylthioxanthone or isopropylthioxanthone; and benzophenone and acrylate derivatives having a tertiary amino group, and addition of tertiary amines. An amine compound is commonly employed to decrease an oxygen polymerization inhibition or to increase sensitivity. However, when an amine compound is used in combination with a high acid value compound, the storage stability at high temperature tends to be decreased. Therefore, specifically, the use of an amine compound with a high acid value compound in inkjet printing should be avoided.
Synergist additives may be used to improve the curing quality and to diminish the influence of the oxygen inhibition. Such additives include, but are not limited to ACTILANE® 800 and ACTILANE® 725 available from AKZO NOBEL, Ebecryl® P115 and Ebecryl® 350 available from UCB CHEMICALS and CD 1012, Craynor CN 386 (amine modified acrylate) and Craynor CN 501 (amine modified ethoxylated trimethylolpropane triacrylate) available from CRAY VALLEY.

The content of the synergist additive is in the range of 0 to 20 wt.%, preferably in the range of 5 to 15 wt.%, based on the total weight of the curable jettable liquid.

### Elastomeric binder

The elastomeric binder may be a single binder or a mixture of various binders. The elastomeric binder is an elastomeric copolymer of a conjugated diene-type monomer and a polyene monomer having at least two non-conjugated double bonds, or an elastomeric copolymer of a conjugated diene-type monomer, a polyene monomer having at least two non-conjugated double bonds and a vinyl monomer copolymerizable with these monomers.
Preferred elastomeric binders are disclosed in EP-A 1637926 paragraph [0092] and [0093].

However, due to their high molecular weight, the addition of elastomeric binders may cause an increase in viscosity of the jettable fluid. Therefore, the amount of elastomeric binder is preferably less than 5 wt.%. In a particular preferred embodiment, no elastomeric binder is added.

### Surfactants

The surfactant(s) may be anionic, cationic, non-ionic, or zwitterionic and are usually added in a total amount below 20 wt.%, more preferably in a total amount below 10 wt.%, each based on the total curable jettable liquid weight.

Fluorinated or silicone compounds are preferably used as a surfactant, however, a potential drawback is bleed-out after image formation because the surfactant does not cross-link. It is therefore preferred to use a copolymerizable monomer having surface-active effects, for example, silicone-modified acrylates, silicone modified methacrylates, fluorinated acrylates, and fluorinated methacrylates.

### Colorants

Colorants may be dyes or pigments or a combination thereof. Organic and/or inorganic pigments may be used.
Suitable dyes include direct dyes, acidic dyes, basic dyes and reactive dyes.
Suitable pigments are disclosed in EP-A 1637926 paragraphs [0098] to [0100].
The pigment is present in the range of 0.01 to 10 wt.%, preferably in the range of 0.1 to 5 wt.%, each based on the total weight of curable jettable liquid.

### Solvents

The curable jettable liquid preferably does not contain an evaporable component, but sometimes, it can be advantageous to incorporate an extremely small amount of a solvent to improve adhesion to the ink-receiver surface after UV curing. In this case, the added solvent may be any amount in the range of 0.1 to 10.0 wt.%, preferably in the range of 0.1 to 5.0 wt.%, each based on the total weight of curable jettable liquid.

### Humectants

When a solvent is used in the curable jettable liquid, a humectant may be added to prevent the clogging of the nozzle, due to its ability to slow down the evaporation rate of curable jettable liquid.
Suitable humectants are disclosed in EP-A 1637926 paragraph [0105]. A humectant is preferably added to the curable jettable liquid formulation in an amount of 0.01 to 20 wt.% of the formulation, more preferably in an amount of 0.1 to 10 wt.% of the formulation.

### Biocides

Suitable biocides include sodium dehydroacetate, 2-phenoxyethanol, sodium benzoate, sodium pyridinethion-1-oxide, ethyl p-hydroxybenzoate and 1,2-benzisothiazolin-3-one and salts thereof. A preferred biocide is Proxel® GXL available from ZENECA COLOURS.
A biocide is preferably added in an amount of 0.001 to 3 wt.%, more preferably in an amount of 0.01 to 1.00 wt.%, each based on the total weight of the curable jettable liquid.

### Preparation of a curable jettable fluid

The curable jettable liquids may be prepared as known in the art by mixing or dispersing the ingredients together, optionally followed by milling, as described for example in EP-A 1637322 paragraph [0108]and [0109].

### Viscosity of the curable jettable fluid

In order that the curable jettable fluid can be used with printheads having small nozzle diameters, for example producing 3 pl fluid droplets, the viscosity of the curable jettable fluid at jetting temperature is less than 15 mPa.s, preferably less than 12 mPa.s, more preferably less than 10 mPa.s.

### Method of preparing a flexographic printing master

The second embodiment of the present invention is a method of preparing a flexographic printing master comprising the steps of:
- providing a flexographic support;
- jetting a curable fluid as described above;
- at least partially curing each jetted layer before a following layer is applied.

Preferred methods of preparing the flexographic printing master are disclosed in EP-As 1637322, 2199081, 2199082 and WO2008/077850 and in the unpublished EP-A 10163064.8 (filed 2010-05-18).

### Flexographic printing support

Two forms of flexographic printing supports may be used: a plate form and a cylindrical form, the latter commonly referred to as a sleeve. If the print master is created as a plate form on a flatbed inkjet device, the mounting of the plate form on a printing cylinder may introduce mechanical distortions resulting in so-called anamorphic distortion in the printed image. Such a distortion may be compensated by an anamorphic pre-compensation in an image processing step prior to halftoning. Creating the print master directly on a sheet form mounted on a print cylinder or directly on a sleeve avoids the problem of geometric distortion altogether.

Using a sleeve as support provides improved registration accuracy and faster change over time on press. Furthermore, sleeves may be well-suited for mounting on an inkjet printer having a rotating drum, as shown in Figure 1. This also makes it possible to create seamless flexographic printing sleeves, which have applications in printing continuous designs such as in wallpaper, decoration, gift wrapping paper and packaging.

The term "flexographic printing support", often encompasses two types of support:
- a support without elastomeric layers on its surface; and
- a support with one or more elastomeric layers on its surface. The one or more elastomeric layers form the so-called elastomeric floor.

In the method of the present invention, the flexographic printing support referred to is a support, preferably a sleeve, without one or more elastomeric layers forming an elastomeric floor. Such a sleeve is also referred to as a basic sleeve or a sleeve base. Basic sleeves typically consist of composites, such as epoxy or polyester resins reinforced with glass fibre or carbon fibre mesh. Metals, such as steel, aluminium, copper and nickel, and hard polyurethane surfaces (e.g. durometer 75 Shore D) can also be used. The basic sleeve may be formed from a single layer or multiple layers of flexible material, as for example disclosed by US2002466668. Flexible basic sleeves made of polymeric films can be transparent to ultraviolet radiation and thereby accommodate backflash exposure for building a floor in the cylindrical printing element. Multiple layered basic sleeves may include an adhesive layer or tape between the layers of flexible material. Preferred is a multiple layered basic sleeve as disclosed in US5301610. The basic sleeve may also be made of non-transparent, actinic radiation blocking materials, such as nickel or glass epoxy. The basic sleeve typically has a thickness from 0.1 to 1.5 mm for thin sleeves and from 2 mm to as high as 100 mm for other sleeves. For thick sleeves often combinations of a hard polyurethane surface with a low-density polyurethane foam as an intermediate layer combined with a fibreglass reinforced composite core are used as well as sleeves with a highly compressible surface present on a sleeve base. Depending upon the specific application, sleeve bases may be conical or cylindrical. Cylindrical sleeve bases are used primarily in flexographic printing.
The basic sleeve or flexographic printing sleeve is stabilized by fitting it over a steel roll core known as an air mandrel or air cylinder. Air mandrels are hollow steel cores which can be pressurized with compressed air through a threaded inlet in the end plate wall. Small holes drilled in the cylindrical wall serve as air outlets. The introduction of air under high pressure permits to float the sleeve into position over an air cushion. Certain thin sleeves are also expanded slightly by the compressed air application, thereby facilitating the gliding movement of the sleeve over the roll core. Foamed adapter or bridge sleeves are used to "bridge" the difference in diameter between the air-cylinder and a flexographic printing sleeve containing the printing relief. The diameter of a sleeve depends upon the required repeat length of the printing job.

### Apparatus for creating the flexographic printing master

Various embodiments of an apparatus for creating the flexographic printing master by inkjet printing may be used. In principle a flat bed printing device may be used, however, a drum based printing device is preferred. A particularly preferred drum (140) based printing device (100) using a sleeve body (130) as flexographic support is shown in Figure 1. The rotating drum (140) is driven by a motor (110).

### Printhead

The means for inkjet printing includes any device capable of coating a surface by breaking up a radiation curable fluid into small droplets which are then directed onto the surface. In the most preferred embodiment the radiation curable fluids are jetted by one or more printing heads ejecting small droplets in a controlled manner through nozzles onto a flexographic printing support, which is moving relative to the printing head(s). A preferred printing head for the inkjet printing system is a piezoelectric head. Piezoelectric inkjet printing is based on the movement of a piezoelectric ceramic transducer when a voltage is applied thereto. The application of a voltage changes the shape of the piezoelectric ceramic transducer in the printing head creating a void, which is then filled with radiation curable fluid. When the voltage is again removed, the ceramic returns to its original shape, ejecting a drop of fluid from the print head. However the inkjet printing method is not restricted to piezoelectric inkjet printing. Other inkjet printing heads can be used and include various types, such as a continuous type and thermal, electrostatic and acoustic drop on demand types. At high printing speeds, the radiation curable fluids must be ejected readily from the printing heads, which puts a number of constraints on the physical properties of the fluid, e.g. a low viscosity at the jetting temperature, which may vary from 25°C to 110°C and a surface energy such that the printing head nozzle can form the necessary small droplets.
An example of a printhead according to the current invention is capable to eject droplets having a volume between 0.1 and 100 picoliter (pl) and preferably between 1 and 30 pl. Even more preferably the droplet volume is in a range between 1 pl and 8 pl. Even more preferably the droplet volume is only 2 or 3 pl.

The unpublished EP-A's 10173533.0 and 10173538.9 (both filed 2010-08-20) and 10158421.7 (filed 2010-03-30) preferred constellations of multiple printheads, preferably back to back printheads, are disclosed.

### Curing

Typically for each layer of the relief image, immediately after the deposition of a fluid droplet by the printhead the fluid droplet is exposed by a curing source. This provides immobilization and prevents the droplets to run out, which would deteriorate the quality of the print master. Such curing of applied fluid drops is often referred to as "pinning".

Curing can be "partial" or "full". The terms "partial curing" and "full curing" refer to the degree of curing, i.e. the percentage of converted functional groups, and may be determined by, for example, RT-FTIR (Real-Time Fourier Transform Infa-Red Spectroscopy) which is a method well known to the one skilled in the art of curable formulations. Partial curing is defined as a degree of curing wherein at least 5 %, preferably 10 %, of the functional groups in the coated formulation or the fluid droplet is converted. Full curing is defined as a degree of curing wherein the increase in the percentage of converted functional groups with increased exposure to radiation (time and/or dose) is negligible. Full curing corresponds with a conversion percentage that is within 10 %, preferably 5 %, from the maximum conversion percentage. The maximum conversion percentage is typically determined by the horizontal asymptote in a graph representing the percentage conversion versus curing energy or curing time. When in the present application the term "no curing" is used, this means that less than 5 %, preferably less than 2.5 %, most preferably less than 1 %, of the functional groups in the coated formulation or the fluid droplet are converted. In the method according to the present invention, applied fluid droplets which are not cured are allowed to spread or coalesce with adjacent applied fluid droplets.

Curing may be performed by heating (thermal curing) or by exposing to actinic radiation (e.g. UV curing). Preferably the curing process is performed by UV radiation.

The curing means may be arranged in combination with the inkjet printhead, travelling therewith so that the curable fluid is exposed to curing radiation very shortly after been jetted (see Figure 1, curing means 150, printhead 160). It may be difficult to provide a small enough radiation source connected to and travelling with the print head. Therefore, a static fixed radiation source may be employed, e.g. a source of UV-light, which is then connected to the printhead by means of flexible radiation conductive means such as a fibre optic bundle or an internally reflective flexible tube.

Alternatively, a source of radiation arranged not to move with the print head, may be an elongated radiation source extending transversely across the flexographic printing support surface to be cured and parallel with the slow scan direction of the print head (see Figure 1, curing means 170). With such an arrangement, each applied fluid droplet is cured when it passes beneath the curing means 170. The time between jetting and curing depends on the distance between the printhead and the curing means 170 and the rotational speed of the rotating drum 140.

A combination of both curing means 150 and 170 can also be used as depicted in Figure 1.

Any UV light source, as long as part of the emitted light can be absorbed by the photo-initiator or photo-initiator system of the fluid droplets, may be employed as a radiation source, such as, a high or low pressure mercury lamp, a cold cathode tube, a black light, an ultraviolet LED, an ultraviolet laser, and a flash light. For curing the inkjet printed radiation curable fluid, the imaging apparatus preferably has a plurality of UV light emitting diodes. The advantage of using UV LEDs is that it allows a more compact design of the imaging apparatus.
UV radiation is generally classified as UV-A, UV-B, and UV-C as follows:
- UV-A: 400 nm to 320 nm
- UV-B: 320 nm to 290 nm
- UV-C: 290 nm to 100 nm

The most important parameters when selecting a curing source are the spectrum and the intensity of the UV-light. Both parameters affect the speed of the curing. Short wavelength UV radiation, such as UV-C radiation, has poor penetration capabilities and enables to cure droplets primarily on the outside. A typical UV-C light source is low pressure mercury vapour electrical discharge bulb. Such a source has a small spectral distribution of energy, with only a strong peak in the short wavelength region of the UV spectrum.

Long wavelength UV radiation, such as UV-A radiation, has better penetration properties. A typical UV-A source is a medium or high pressure mercury vapour electrical discharge bulb. Recently UV-LEDs have become commercially available which also emit in the UV-A spectrum and that have the potential to replace gas discharge bulb UV sources. By doping the mercury gas in the discharge bulb with iron or gallium, an emission can be obtained that covers both the UV-A and UV-C spectrum. The intensity of a curing source has a direct effect on curing speed. A high intensity results in higher curing speeds.
The curing speed should be sufficiently high to avoid oxygen inhibition of free radicals that propagate during curing. Such inhibition not only decreases curing speed, but also negatively affects the conversion ratio of monomer into polymer. To minimize such oxygen inhibition, the imaging apparatus preferably includes one or more oxygen depletion units. The oxygen depletion units place a blanket of nitrogen or other relatively inert gas (e.g. CO₂), with adjustable position and adjustable inert gas concentration, in order to reduce the oxygen concentration in the curing environment. Residual oxygen levels are usually maintained as low as 200 ppm, but are generally in the range of 200 ppm to 1200 ppm.
Another way to prevent oxygen inhibition is the performance of a low intensity pre-exposure before the actual curing.

A partially cured fluid droplet is solidified but still contains residual monomer. This approach improves the adhesion properties between the layers that are subsequently printed on top of each other. Partial intermediate curing is possible with UV-C radiation, UV-A radiation or with broad spectrum UV radiation. As mentioned above, UV-C radiation cures the outer skin of a fluid droplet and therefore a UV-C partially cured fluid droplet will have a reduced availability of monomer in the outer skin and this negatively affects the adhesion between neighbouring layers of the relief image. It is therefore preferred to perform the partial curing with UV-A radiation.

A final post curing however is often realized with UV-C light or with broad spectrum UV light. Final curing with UV-C light has the property that the outside skin of the print master is fully hardened.

### EXAMPLES

### Materials

All materials used in the examples were readily available from standard sources such as Aldrich Chemical Co. (Belgium) and Acros (Belgium) unless otherwise specified.
- SR506D is an isobornylacryate available from Sartomer.
- Genomer 1122 is a low viscous monofunctional urethane acrylate (2-acrylic acid 2-(((acryl-amino)carbonyl)oxy)ethylester) from RAHN.
- SR610 is a polyethylene glycol (600) diacrylate from Sartomer.
- Ebecryl 1360 is silicone hexaacrylate from Cytec.
- SR340 is a 2-phenoxy ethyl methacrylate from SARTOMER.
- Agfarad is a mixture of 4 wt.% p-methoxyphenol, 10 wt.% 2,6-di-tert-butyl-4-methylfenol and 3.6 wt.% Aluminium N-nitroso-phenylhydroxylamine (available from CUPFERRON AL) in DPGDA.
- DPGDA is a dipropylene glycol diacrylate available from UCB.
- Ebecryl P36 is an acrylated benzophenone derivative from Cytec.
- Irgacure 819 is a UV-photoinitiator from CIBA.
- Genopol TX-1 is a polymeric thioxantone derivate from Rahn.
- Genopol AB-1 is a polymeric aminobenzoate derivative from Rahn.
- Genocure ITX is a thioxantone photo-initiator from Rahn.
- Genocure EPD is an amino benzoate co-initiator from Rahn.

### Example 1

This example illustrates the embodiment wherein the initiator is a copolymerizable compound.

The curable fluids INV-1 and COMP-1 were prepared by mixing the ingredients listed in Table 1.

**Table 1**

| Ingredient (wt.%) | INV-1 | COMP-1 |
|---|---|---|
| SR506D | 48.50 | 48.50 |
| Genomer 1122 | 15.30 | 15.30 |
| SR340 | 10.00 | 10.00 |
| SR610 | 20.40 | 20.40 |
| Ebecryl® 1360 | 0.03 | 0.03 |
| Ebecryl® P36 | 5.00 | - |
| Benzophenon | - | 5.00 |
| visco @ 45°C (mPa.s) | 8.1 | 7.1 |

The viscosity of the curable jettable fluids was measured with a Brookfield DV-II+Pro viscometer using the programs 6T (25°C, 6 rpm) and 12T (45°C, 12 rpm).

The UV curable compositions of Table 1 were coated at a thickness of 10 µm on a biaxially oriented polyester film Lumirror X43 from Toray. After being cured during 3 minutes in a nitrogen atmosphere under UV-A light (370 nm) and 10 minutes under UV-C light (254 nm), the cured coating was peeled off from its support.

The cured samples were immersed during 30 minutes at room temperature in the following solvent mixtures:

**Solvent mixture 1**

| | |
|---|---|
| n. propanol | 26.3% |
| isopropanol | 26.3% |
| propylene glycol methyl ester | 26.3% |
| n. propyl acetate | 13.1% |
| ethanol | 4.0% |
| propylene glycol n. butyl ester | 4.0% |

**Solvent mixture 2**

| | |
|---|---|
| 1-propoxy-2-propanol | 64.1% |
| ethanol | 24.9% |
| isopropanol | 4.1% |
| ethyl acetate | 3.7% |
| n.propyl acetate | 3.2% |

The amount of extracted photo-initiator (see Table 2) was determined with HPLC.

**Table 2**

| Example | % photo-initiator extracted | |
|---|---|---|
| | Solvent 1 | Solvent 2 |
| INV-1 | 0 % | 0 % |
| COMP-1 | 86 % | 62 % |

From the results shown in Table 2 it is clear that for the inventive example comprising a copolymerizable initiator (Ebecryl P36), no initiator is extracted from the cured sample while for the comparative example comprising a conventional initiator (Benzophenon), a substantial amount of the initiator extracted by the solvents used.

To evaluate the usefulness as UV curable fluids for making a flexographic printing master by means of inkjet, the hardness, the elongation at break and the creep recovery of the cured fluids were evaluated.

### Hardness Determination

Standard measurements of the hardness of various substances are currently performed using durometer hardness test procedures, such as those set forth in ASTM D2240. The durometer hardness procedures are used for determining indentation hardness of various substances, and are particularly useful for elastomeric materials. These test methods measure the depression force of a specific type of indentor as it is forced under specific conditions against the material's surface. Due to the various parameters which influence hardness determinations, different durometer scales have been established. A particular scale is chosen depending on the type of material to be measured. For example, materials which are relatively soft, such as elastomeric materials, are measured on a Shore A scale. Shore A scale measurements use a steel rod indentor shaped with a blunt end, and a calibrated spring force. The indentor descends at a controlled rate against the specimen surface and a reading is recorded within a specified time period. This procedure is repeated multiple times at different positions on the specimen and the arithmetic mean of the results yields the Shore A measurement.

The samples to be measured were prepared as follows. A petri dish made out of polystyrene and having a diameter of 5.6 cm was filled with 10 g of the curable fluids.
Assuming that the specific weight of the liquid photopolymer is approx. 1.015 g/ml, the height of the added photopolymer was ± 4 mm (volumetric shrinkage not taken in account). The filled petri dish was placed in a quartz glass box filled up with Nitrogen.
The samples were exposed with UV-A light in a light box equipped with 8 Philips TL 20W/10 UVA (λₘₐₓ = 370nm).
The distance between the lamp and the sample was approx. 10 cm.
The Curing time was 10 minutes. Subsequently the samples were back exposed during 10 min. After releasing the disk-shaped UV-A cured fluids out of the Petri dish, a UV-C post-curing (also making use of the quartz box filled with nitrogen) was carried out.
This treatment was carried out in a light-box equipped with 4 Philips TUV lamps (λₘₐₓ = 254 nm). The upper side was cured during 20 minutes.

### Elongation at break

Elongation at break, expressed as a percentage compared to the initial length at rest, corresponds to the maximum elongation prior to breaking.

Elongation at break, expressed as a percentage compared to the initial length at rest, corresponds to the maximum elongation attained prior to breaking.

Strips made of 2 adhered layers of a Tesa plate mounting tape 52338 (thickness 0.5 mm incl. protective layer) with a width of 1.5 cm were mounted on the border of a Lumirror X43 support from Toray in the linear direction. These guidance border strips were used in combination with a 100 µm coating knife and acted as a spacing aid to obtain a final coated/cured layer thickness of approx. 0.38 mm.

The coated layer was then placed very cautious (must be kept perfectly horizontal to avoid spreading out) in a quartz glass box filled with nitrogen gas before curing.

UV-A curing was carried out with a UV-A Light box equipped with 8 Philips TL 20W/10 UVA (max = 370nm) lamps. The distance between the lamp and the sample was approx. 10cm. Curing time was 3 minutes.

After this step, a UV-C post-treatment step was carried out. UV-C post-curing was carried out with a light-box equipped with 4 Philips TUV lamps (max = 254 nm). Post-curing was also performed under N₂ and the curing time was 20 minutes.

Then, a T-bone shaped sample (150 mm X 19 mm) was cut out and the polymerized layer was stripped of from its temporary support.

Elongation at break measurements were carried out on Instron 4469 Universal Testing Machine (stretching with an elongation speed of 10mm/min @ 22°C).

### Creep recovery after static compression

Creep recovery reflects the resistance of a material to deform permanently to relieve stresses. To determine creep properties, a sample is subjected to prolonged constant tension or compression at constant temperature. Deformation is recorded at specified time intervals and a creep vs. time diagram is plotted. The slope of the curve at any point is the creep rate. If the specimen does not fracture within the test period, the creep recovery can be measured.

A circular cured sample of the curable jettable liquid (prepared as described for the T-bone sample in the elongation at break test method), having a diameter of 6.2 mm and a thickness of 0.38 mm, was deformed in a Texas Instruments DMA 2980 (dynamic mechanical analysis) apparatus with a ball point probe having a diamter of 2.7 mm during 5 minutes with a set pressure of 0.005 MPa.
After release of the pressure, creep recovery is determined after 1.2 s, the shortest measurable recovery time.

The results of these measurements are given in Table 3.
Good results are obtained when:
- The hardness (Shore A) is less than 80
- The elongation at break is at least 30%
- The creep recovery is higher than 70% after 1.2 seconds.

**Table 3**

| | COMP-1 | INV-1 |
|---|---|---|
| Elongation at break | 39 % | 37 % |
| Creep recovery | 90 % | 84 % |
| Hardness (Shore A) | 59 | 61 |

From the results in Table 3 it is clear that with the inventive curable fluids, flexographic printing masters with good physical properties can be prepared.

### Example 2

This example illustrates the embodiment wherein the initiator and the co-initiator is a polymeric compound.

The curable fluids INV-2 and COMP-2 were prepared by mixing the ingredients listed in Table 4.

**Table 4**

| Ingredient (wt.%) | INV-2 | COMP-2 |
|---|---|---|
| SR506D | 23.00 | 23.00 |
| Genomer 1122 | 18.40 | 18.40 |
| SR340 | 23.00 | 23.00 |
| SR610 | 23.00 | 23.00 |
| Ebecryl 1360 | 0.03 | 0.03 |
| Genopol TX-1 | 4.00 | - |
| Genopol AB-1 | 8.00 | - |
| Genocur ITX | - | 4.0 |
| Genocure EPD | - | 8.0 |

The UV curable compositions of Table 4 were coated at a thickness of 10 µm on a subbed polyester substrate. After being cured during 5 minutes in a nitrogen atmosphere under UV-A (370 nm) light and 10 minutes under UV-C (254 nm) light, the cured coated layers were immersed during 30 min. at room temperature in acetonitrile and are shown in Table 5. The amount of extracted photo-initiator and co-initiator was determined with HPLC.

**Table 5**

| Example | % photo-initiator extracted | % co-initiator extracted |
|---|---|---|
| INV-2 | 17% | 20% |
| COMP-2 | 28% | 64% |

From the results shown in Table 5 it is clear that with the inventive example comprising a polymeric initiating system (initiator and co-initiator) the amount of extracted initiator and/or co-initiator is less compared to the comparative example comprising a conventional initiator and co-initiator.

## Claims

1. A curable jettable fluid for making a flexographic printing master comprising an initiator, the initiator is an oligomer, a polymer or a copolymerizable compound, a difunctional (meth)acrylate monomer, the difunctional (meth)acrylate monomer is a polyalkylene glycol di(meth)acrylate, optionally a polymerizable co-initiator, and a cyclic monofunctional (meth) acrylate monomer selected from the group of isobornyl acrylate, tetrahydrofurfuryl methacrylate, 4-t.butylcyclohexyl arylate, dicyclopentadienyl acrylate, dioxalane functional acrylates, cyclic trimethylolpropane formal acrylate, 2-phenoxyethyl acrylate, 2-phenoxyethyl methacrylate, tetrahydrofurfuryl acrylate and 3,3,5-trimethyl cyclohexyl acrylate.

2. The curable jettable fluid according to claim 1 wherein the initiator is an oligomer or polymer selected from a thioxantone or benzophenone derivative.

3. The curable jettable fluid according to claim 1 wherein the initiator is a copolymerizable benzophenone derivative.

4. The curable jettable fluid according to claim 3 wherein the initiator is an acrylated benzophenone derivative.

5. The curable jettable fluid according to any of the preceding claims wherein the amount of cyclic monofunctional (meth)acrylate monomer is at least 40 wt% relative to the total monomer content.

6. The curable jettable fluid according to any of the preceding claims wherein the curable jettable fluid further comprises a copolymerizable plasticizing monomer selected from the group consisting of diallyl phthalate and a low Tg monomer, of which the corresponding homopolymer has a glass transition temperature (Tg) below -15°C.

7. The curable jettable fluid according to claim 6 wherein the copolymerizable plasticizing monomer is a low Tg, C₈-C₁₆ alkyl acrylate monomer.

8. The curable jettable fluid according to any of the preceding claims having a viscosity at jetting temperature of less than 15 mPa.s.

9. A method of preparing a flexographic printing master comprising the steps of:
- providing a flexographic support;
- jetting a curable fluid as defined in any of the claims 1 to 8 on said support;
- at least partially curing each jetted layer before a following layer is applied.

## Patentansprüche

1. Ein härtbares aufspritzbares Fluid zur Herstellung eines flexografischen Druckmasters, enthaltend einen Initiator, der ein Oligomer, ein Polymer oder eine copolymerisierbare Verbindung ist, ein difunktionelles (Meth)acrylatmonomer, das ein Polyalkylenglycoldi(meth)acrylat ist, gegebenenfalls einen polymerisierbaren Coinitiator, und ein cyclisches monofunktionelles (Meth)acrylatmonomer, ausgewählt aus der Gruppe bestehend aus Isobornylacrylat, Tetrahydrofurfurylmethacrylat, 4-t.Butylcyclohexylacrylat, Dicyclopentadienylacrylat, Acrylaten mit Dioxalanfunktion, cyclischem Trimethylolpropanformalacrylat, 2-Phenoxyethylacrylat, 2-Phenoxyethylmethacrylat, Tetrahydrofurfurylacrylat und 3,3,5-Trimethylcyclohexylacrylat.

2. Das härtbare aufspritzbare Fluid nach Anspruch 1, wobei der Initiator ein Oligomer oder Polymer, ausgewählt aus einem Thioxanton-Derivat oder Benzophenon-Derivat, ist.

3. Das härtbare aufspritzbare Fluid nach Anspruch 1, wobei der Initiator ein copolymerisierbares Benzophenon-Derivat ist.

4. Das härtbare aufspritzbare Fluid nach Anspruch 3, wobei der Initiator ein acryliertes Benzophenon-Derivat ist.

5. Das härtbare aufspritzbare Fluid nach einem der vorstehenden Ansprüche, wobei die Menge des cyclischen monofunktionellen (Meth)acrylatmonomers bei mindestens 40 Gew.-%, bezogen auf den Gesamtmonomergehalt, liegt.

6. Das härtbare aufspritzbare Fluid nach einem der vorstehenden Ansprüche, wobei das härtende aufspritzbare Fluid ferner ein copolymerisierbares weichmachendes Monomer, ausgewählt aus der Gruppe bestehend aus Diallylphthalat und einem Monomer mit niedriger Tg, dessen entsprechendes Homopolymer eine Glasübergangstemperatur (Tg) unter -15°C aufweist, enthält.

7. Das härtbare aufspritzbare Fluid nach Anspruch 6, wobei das copolymerisierbare weichmachende Monomer ein C₈-C₁₆-Alkylacrylatmonomer mit niedriger Tg ist.

8. Das härtbare aufspritzbare Fluid nach einem der vorstehenden Ansprüche, das eine Viskosität bei Aufspritztemperatur von weniger als 15 mPa·s aufweist.

9. Ein Verfahren zur Herstellung eines flexografischen Druckmasters, umfassend die folgenden Schritte:
- Bereitstellen eines flexografischen Trägers,
- Aufspritzen eines wie nach einem der Ansprüche 1 bis 8 definierten härtbaren Fluids auf den Träger,
- mindestens teilweises Härten jeder aufgespritzen Schicht, ehe eine nächste Schicht aufzutragen.

## Revendications

1. Fluide durcissable applicable par jet pour la fabrication d'une matrice d'impression flexographique, contenant un initiateur qui est un oligomère, un polymère ou un composé copolymérisable, un monomère de (méth)acrylate difonctionnel qui est un di(méth)acrylate de polyalkylène glycol, éventuellement un coinitiateur polymérisable, et un monomère de (méth)acrylate monofonctionnel cyclique choisi parmi le groupe composé d'acrylate d'isobornyle, de méthacrylate de tétrahydrofurfuryle, d'acrylate de 4-t.butylcyclohexyle, d'acrylate de dicyclopentadiényle, d'acrylates à fonction de dioxalane, d'acrylate de triméthylolpropaneformal cyclique, d'acrylate de 2-phénoxyéthyle, de méthacrylate de 2-phénoxyéthyle, d'acrylate de tétrahydrofurfuryle et d'acrylate de 3,3,5-triméthylcyclohexyle.

2. Fluide durcissable applicable par jet selon la revendication 1, **caractérisé en ce que** l'initiateur est un oligomère ou polymère choisi parmi un dérivé de thioxantone ou un dérivé de benzophénone.

3. Fluide durcissable applicable par jet selon la revendication 1, **caractérisé en ce que** l'initiateur est un dérivé de benzophénone copolymérisable.

4. Fluide durcissable applicable par jet selon la revendication 3, **caractérisé en ce que** l'initiateur est un dérivé de benzophénone acrylé.

5. Fluide durcissable applicable par jet selon l'une quelconque des revendications précédentes, **caractérisé en ce que** la quantité du monomère de (méth)acrylate monofonctionnel cyclique s'élève à au moins 40% en poids par rapport à la teneur en monomère totale.

6. Fluide durcissable applicable par jet selon l'une quelconque des revendications précédentes, **caractérisé en ce que** ledit fluide durcissable applicable par jet contient en outre un monomère plastifiant copolymérisable choisi parmi le groupe composé dé phtalate de diallyle et d'un monomère à basse Tg dont l'homopolymère correspondant présente une température de transition vitreuse (Tg) inférieure à -15°C.

7. Fluide durcissable applicable par jet selon la revendication 6, **caractérisé en ce que** ledit monomère plastifiant copolymérisable est un monomère d'acrylate d'alkyle en C₈-C₁₆ à basse Tg.

8. Fluide durcissable applicable par jet selon l'une quelconque des revendications précédentes présentant une viscosité à la température de projection qui est inférieure à 15 mPa·s.

9. Procédé pour la fabrication d'une matrice d'impression flexographique, comprenant les étapes consistant à:
- mettre à disposition un support flexographique,
- projeter un fluide durcissable tel que défini selon l'une quelconque des revendications 1 à 8 sur ledit support,
- durcir au moins partiellement chaque couche appliquée par jet avant d'appliquer une couche suivante.
